## Europäisches Patentamt

## European Patent Office

## Office européen des brevets

(19)

(11) Veröffentlichungsnummer: **0 186 655**
A2

(12) # EUROPÄISCHE PATENTANMELDUNG

(21) Anmeldenummer: **85890317.2**

(22) Anmeldetag: **23.12.85**

(51) Int. Cl.⁴: **H 05 K 3/44**

(30) Priorität: **27.12.84 DE 3447520**

(43) Veröffentlichungstag der Anmeldung:
**02.07.86 Patentblatt 86/27**

(84) Benannte Vertragsstaaten:
**AT DE FR NL SE**

(71) Anmelder: **VOEST-ALPINE Aktiengesellschaft**
**Muldenstrasse 5**
**A-4020 Linz(AT)**

(72) Erfinder: **Tippelt, Werner, Dipl.-Ing.**
**Glaserstrasse 12**
**A-4040 Linz(AT)**

(72) Erfinder: **Scharizer, Walter, Dr.**
**Haid 51**
**A-4210 Gallneukirchen(AT)**

(74) Vertreter: **Matschnig, Franz, Dipl.-Ing.**
**Siebensterngasse 54 Postfach 452**
**A-1071 Wien(AT)**

(54) Verfahren zur Herstellung einer Verbundleiterplatte.

(57) Dieses verfahren dient zur Herstellung einer Verbundleiterplate od.dgl. mit einem Metallkern (1), einer Isolierschicht (2) und einer auf dieser angeordneten Leiterschicht (5).

Um feste und gleichmäßige Beschichtungen mit guter Wärmeleitfähigkeit zu erhalten, ist vorgesehen, daß gegebenenfalls unter Bildung von Zwischenschichten, z.B. Haftvermittlungsschichten, auf den aus einem hochwärmefesten Metall, z.B. aus Molybdän, Wolfram, Titan oder einer Molybdän-Mangan Legierung bestehenden Metallkern (1) durch chemische Abscheidung in der Gasphase eine isolierende anorganische Schicht (2) aufgebracht und hierauf durch chemische Naßabscheidung die Leiterschicht (5) abgeschieden wird. Der Metallkern (1) kann hiebei aus hochlegiertem Stahl mit einer Permeabilität $\mu < 1,002$ bestehen und als isolierende schicht (2) kann Aluminiumnitrid aufgebracht werden.

Fig. 1

EP 0 186 655 A2

## Verfahren zur Herstellung einer Verbundleiterplatte

Die Erfindung bezieht sich auf ein Verfahren zur Herstellung einer Verbundleiterplatte od.dgl. mit einem Metallkern, einer Isolierschicht und einer auf dieser angeordneten Leiterschicht, z.B. aus Kupfer.

Zufolge der immer mehr steigenden Packungsdichte bei elektronischen Schaltungen versucht man, die Leiterplatten, auf welchen die einzelnen Bauteile angeordnet sind, zusätzlich zu den bekannten Kühlkörpern, die z.B. auf Schaltungsbausteine aufgesteckt sind, zur Wärmeableitung heranzuziehen. Daher sind Verbundleiterplatten bekannt geworden, deren Trägerschicht aus Metall, z.B. aus Kupfer, Stahl, Aluminium, u.s.w. besteht. Auf diese Trägerschicht ist eine isolierende Schicht, entweder aus Kunststoff oder aus Email, aufgebracht. Auf die Isolierschicht ist die Leiterschicht aufgebracht und zwar entweder vollflächig, sodaß später die Leiterbahnen freigeätzt werden müssen oder bereits in der erforderlichen Leiterbahnkonfiguration.

Bei diesen bekannten Leiterplatten weist zwar die metallische Trägerschicht die erforderliche Wärmeleitfähigkeit auf, doch liegt eine gewisse Problematik in der Isolierschicht. Bei Verwendung von Kunststoffen muß auf deren im allgemeinen geringe Temperaturbeständigkeit Rücksicht genommen werden. Da die Schichtdicke aus fertigungstechnischen Gründen verhältnismäßig groß ist und die Wärmeleitfähigkeit von Kunststoffen schlecht ist,

0186655

- 2 -

tritt zwischen der Leiterschicht und der metallischen Trägerschicht ein hoher Wärmewiderstand auf, der die Wärmeableitung in die Trägerschicht in Frage stellt. Davon abgesehen führt die hohe Dielektrizitätskonstante der gebräuchlichen Kunststoffe in einigen Anwendungsfällen zu untragbaren Kapazitäten zwischen einzelnen Leiterbahnen bzw. zwischen diesen und der Trägerschicht.

Die Verwendung einer Isolierschicht aus Email löst zwar das Problem der Temperaturempfindlichkeit und auch die Wärmeleitfähigkeit ist besser als bei Kunststoffen. Andererseits ist eine Emailschicht schwierig aufzubringen; sie bietet bei dünnen Schichtstärken nicht genügend Porenfreiheit und eine Beschichtung unzugänglicher Stellen, etwa der Innenfläche von Bohrlöchern, ist nicht möglich.

Die vorhin erwähnte Erwärmung der elektronischen Bauteile und in der Folge der Leiterplatte bringt weitere Probleme wegen der unterschiedlichen Ausdehnungskoeffizienten der Leiterplatte bzw. deren Schichten einerseits und der Bauteile andererseits mit sich, da wegen der wiederholt auftretenden mechanischen Spannungsspiele beispielsweise die Lötverbindungen aufbrechen können. Es muß daher gefordert werden, daß die Leiterplatte einen Wärmeausdehnungskoeffizienten aufweist, der möglichst nahe dem üblichen elektronischer Bauelemente liegt.

Es ist bereits bekannt geworden (DE-OS 30 35 749) eine Leiterplatte aus einem Eisenkern mit einer Galvanoaluminiumeloxalschicht als Isolierschicht zu versehen.

Gegebenenfalls wird vorher eine Zwischenschicht aus Kupfer auf den Eisenkern aufgebracht. Das Aufbringen von Kupferschichten auf eloxiertes Aluminium durch galvanische Methoden geht aus der US-PS 3,340.164 hervor.

Nach den bekannten Verfahren wird zwar eine verhältnismäßig gut wärmeleitende Schicht geschaffen, doch ist bei galvanisch erzeugten Aluminiumoxydschichten einerseits deren elektrisches Isoliervermögen nicht immer zufriedenstellend und andererseits werden insbesondere kleine Bohrungen nur mangelhaft beschichtet.

Ziel der Erfindung ist die Schaffung eines Verfahrens, das die billige Massenproduktion qualitativ hochwertiger Leiterplatten mit hoher Wärmeableitung und guten Isolationseigenschaften erlaubt.

Dieses Ziel läßt sich mit einem Verfahren der eingangs genannten Art erreichen, bei welchem erfindungsgemäß, gegebenenfalls unter Bildung von Zwischenschichten, z.B. Haftvermittlungsschichten, auf den aus einem hochwärmefesten Metall, z.B. aus Molybdän, Wolfram, Titan oder einer Molybdän-Mangan Legierung bestehenden Metallkern durch chemische Abscheidung in der Gasphase eine isolierende anorganische Schicht aufgebracht und hierauf durch chemische Naßabscheidung die Leiterschicht abgeschieden wird.

Mit dem Verfahren nach der Erfindung lassen sich in Großserien kostengünstig Verbundleiterplatten herstellen, die sehr homogene, mechanisch widerstandsfähige Isolierschichten aufweisen. Die chemische Abscheidung aus der Gasphase - ein mögliches Verfahren ist z.B. in der AT-PS 316.160 beschrieben - ermöglicht es, anorganische isolierende Überzüge gleichmäßig auf Metallflächen aufzubringen, wobei eine Beschichtung sonst unzugänglicher Stellen, wie beispielsweise der Innenfläche von Bohrlöchern möglich ist. Zum Aufbringen der Leiterschicht auf die solcherart hergestellte Isolierschicht eignet sich am besten eine chemische Naßabscheidung, da andere bekannte Verfahren zum Aufbringen etwa einer Kupferschicht auf Aluminiumoxyd keine befriedigenden Ergebnisse bringen. Überdies ist mit diesem Verfahren das Durchkontaktieren von Bohrlöchern, z.B. zur Verbindung der Leiterbahnen zweier Ebenen, leicht möglich.

Es hat sich als zweckmäßig erwiesen, wenn der Metallkern aus hochlegiertem Stahl mit einer Permeabilität $\mu < 1,002$ besteht. Derartige Stähle weisen hohe Anteile an Cr und Ni auf. Sie besitzen die geforderte Wärmefestigkeit und wirken sich günstig auf die elektrischen Übertragungseingenschaften der Leiterplatte aus, da wegen der geringen Permeabilität die unerwünschten Schaltungsinduktivitäten klein gehalten werden können.

Es ist weiters von Vorteil, wenn als isolierende Schicht Aluminiumnitrid aufgebracht wird. Dieses Material weist eine gute Wärmeleitfähigkeit auf, die sogar über der von Aluminiumoxyd liegt, es ist nicht teuer und kann problemlos durch chemische Abscheidung in der Gasphase aufgetragen werden.

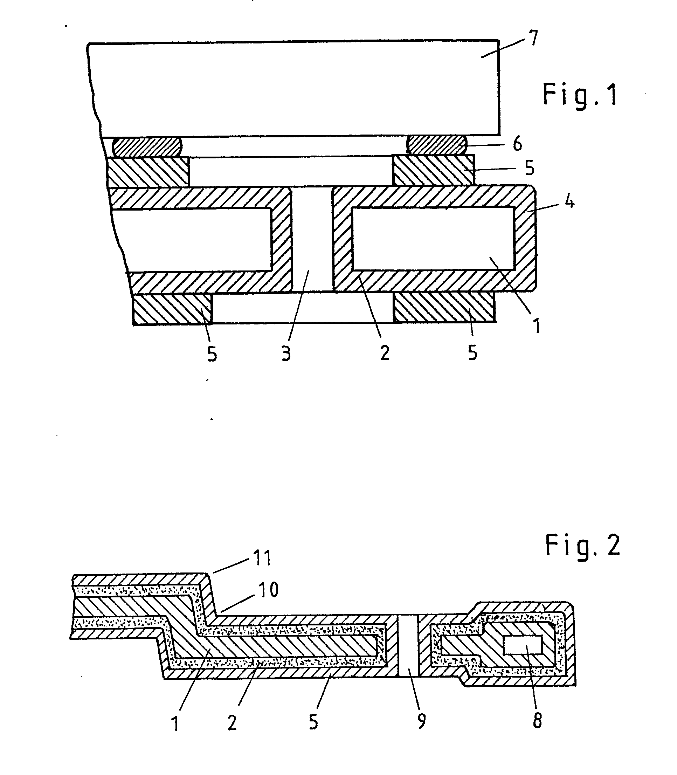

Die Erfindung samt ihren weiteren Vorteilen und Merkmalen ist im folgenden an Hand beispielsweiser Ausführungen näher erläutert, die in der Zeichnung veranschaulicht sind. In dieser zeigen Fig. 1 einen schematischen Schnitt durch eine nach dem erfindungsgemäßen Verfahren herstellbare Zweiebenen-Leiterplatte mit einem aufgelöteten elektronischen Bauteil und Fig.2 gleichfalls einen Schnitt durch eine Zweiebenen-Leiterplatte die nach der Erfindung hergestellt wurde.

Gemäß Fig. 1 ist auf einem Metallkern 1 eine Isolierschicht 2 aus Aluminiumoxyd aufgebracht. Der Metallkern 1 besteht z.B. aus Molybdän und ist als Platte oder Folie ausgebildet. Die Stärke dieser Platte oder Folie wird je nach den Anforderungen an mechanische Stabilität und Wärmewiderstand gewählt, sie liegt bei Ausführungsbeispielen in der Größenordnung von 0,5 bis 2 mm. Wie ersichtlich, ist der Metallkern 1 beiderseitig mit der Isolierschicht 2 bedeckt und die Isolierschicht erstreckt sich auch über die Innenfläche eines Bohrloches 3 und über die Kanten 4 des Metallkerns 1.

Auf der Isolierschicht ist eine Leiterschicht 5 angeordnet, die auf beiden Seiten der Leiterplatte in bekannter Weise aus einzelnen Leiterbahnen besteht. Auf diesen sitzen, mittels einer Lötverbindung 6 leitend mit der Schicht 5 verbunden, elektronische Bauteile, wobei in der Zeichnung an der Oberseite der Leiterplatte ein solcher Bauteil 7 schematisch angeordnet ist.

Die Herstellung einer Leiterplatte nach der Erfindung erfolgt wie nachstehend beschrieben nach einem an sich bekannten Verfahren. Platten oder folienförmige Metallkerne 1 aus Molybdän oder aus einem anderen hochwärmefesten Metall, wie z.B. Wolfram, Titan oder aus einer
Molybdän-Mangan Legierung werden nach entsprechender
Oberflächenvorbehandlung (Reinigung) in einen Beschichtungsofen eingebracht. Dem Ofenraum werden bei relativ
hohen Temperaturen, üblicherweise zwischen 700° - 1100°C,
je nach Art der vorgesehenen Isolierschicht, verschiedene
Gase sowie ein verdampftes Metallhalogenid zugeführt,
wobei der Begriff "hochwärmefest" hier in Hinblick auf
die Verfahrenstemperatur zu verstehen ist. Durch die
chemische Reaktion an der Oberfläche der Metallkerne
bildet sich eine dichte und glatte Isolierschicht 2.
Vorzugsweise wird eine Schicht aus Aluminiumoxyd abgelagert, doch können auch Schichten oder Kombinationen
von Schichten aus Oxyden, Nitriden oder Karbonitriden,
beispielsweise von Titan, Silizium, Beryllium, Magnesium,
Zirkonium, Hafnium, Calcium etc., aufgebracht werden.
Vor allem kann es oft zweckmäßig sein, zwischen Metallkern und Isolierschicht eine Haftvermittlungsschicht
aufzubringen. Ein besonderer Vorteil dieser Beschichtungsart liegt darin, daß auch unzugängliche Stellen, wie
Bohrlöcher, Kanten, Winkel usw. beschichtet werden
können, was mit bekannten Verfahren nicht oder nur
mangelhaft möglich ist.

Als besonders vorteilhaft hat es sich erwiesen, als
Isolierschicht 2 Aluminiumnitrid (AlN) aufzubringen,
da dieses Material nicht nur billig ist sondern eine
gute Wärmeleitfähigkeit aufweist, die sogar über der
von Aluminiumoxyd liegt.

In Hinblick auf die geforderte Wärmefestigkeit aber auch zur Verringerung unerwünschter Leitungsinduktivitäten hat es sich als zweckmäßig erwiesen, den Metallkern 1 aus einem hochlegierten Stahl mit hohen Cr- und Ni-Anteilen und einer Permeabilität $\mu < 1,002$ herzustellen.

Auf den wie oben beschrieben beschichteten Platten oder Folien wird sodann durch chemische Naßabscheidung die Leiterschicht aufgebracht. Diese Schicht besteht in bekannter Weise meist aus Kupfer, Silber oder Gold oder aus der Kombination solcher Schichten. Die Leiterschicht 5 wird hiebei nach einem an sich bekannten Verfahren gut haftend durch einen chemischen Aufschluß der Oberfläche der Isolierschicht aufgebaut und zwar entweder vollflächig, sodaß später durch Ätzung die gewünschten Leiterbahnen erhalten werden oder sogleich in der endgültigen Leiterbahnkonfiguration. Diese Naßabscheidung bietet auch den Vorteil, daß - im Gegensatz etwa zu der Beschichtung durch Plattieren - die Leiterschicht auf sonst unzugängliche Stellen aufgebracht werden kann.

In Fig. 2 ist gleichfalls eine Zweiebenen-Leiterplatte gezeigt, die den gleichen Schichtaufbau wie jene nach Fig. 1 aufweist, doch besitzt diese Ausführung am Rand des Metallkerns 1 einen Kanal 8, durch den ein Kühlmedium strömen kann. Weiters ist ersichtlich, daß bei dieser Ausführung die Innenfläche eines Bohrloches 9 nicht nur mit der Isolierschicht 2 bedeckt sondern auch mittels der Leitschicht 5 durchkontaktiert ist, um Leiterbahnen der beiden Ebenen miteinander zu verbinden. Nach dem erfindungsgemäßen Verfahren hergestellte Leiterplatten können auch beliebig gebogen oder gekrümmt sein, da die Beschichtung von Ecken 10 oder scharfen Kanten 11 ohne Schwierigkeiten möglich ist.

In der Zeichnung sind doppelseitig beschichtete Leiterplatten, sogenannte Zweiebenen-Leiterplatten, gezeigt, doch bezieht sich die Erfindung in gleicher Weise auf Einebenen-Leiterplatten. Wegen der guten Wärmeabfuhr können Leiterplatten nach der Erfindung zu Mehrlagenplatten zusammengefügt werden. Bei hoher Packungsdichte der elektronischen Bauelemente und/oder hoher Verlustwärme der verwendeten Elemente empfiehlt sich eine forcierte Kühlung, z.B. durch in Kanälen nach Fig. 2 zirkulierende Kühlflüssigkeit oder durch ein Kühlgas.

Wenn im Zusammenhang mit der Erfindung von Verbundleiterplatten gesprochen wird, so sind darunter nicht nur Leiterplatten größerer Abmessung für elektronische Einzelbauelemente zu verstehen sondern beispielsweise auch Substrate für Chips. Der Aufbau der Leiterplatte bleibt hiebei gleich, bloß die Abmessungen ändern sich entsprechend.

- 9 -

Patentansprüche

1. Verfahren zur Herstellung einer Verbundleiterplatte od.dgl. mit einem Metallkern, einer Isolierschicht und einer auf dieser angeordneten Leiterschicht, z.B. aus Kupfer, dadurch gekennzeichnet, daß gegebenenfalls unter Bildung von Zwischenschichten, z.B. Haftvermittlungsschichten, auf den aus einem hochwärmefesten Metall, vorzugsweise aus Molybdän, Wolfram, Titan oder einer Molybdän- Mangan Legierung bestehenden Metallkern (1) durch chemische Abscheidung in der Gasphase eine isolierende anorganische Schicht (2) aufgebracht und hierauf durch chemische Naßabscheidung die Leiterschicht (5) abgeschieden wird.

2. Verfahren nach Anspruch 1, dadurch gekennzeichnet, daß der Metallkern (1) aus hochlegiertem Stahl mit einer Permeabilität $\mu<1,002$ besteht.

3. Verfahren nach Anspruch 2, dadurch gekennzeichnet, daß als isolierende Schicht (2) Aluminiumnitrid aufge- bracht wird.

Fig. 1

7

6

5

4

1

5 3 2 5

Fig. 2

11

10

1 2 5 9 8